# EUROPÄISCHE PATENTSCHRIFT

(11) **EP 1 241 926 B1**
(45) Veröffentlichungstag und Bekanntmachung des Hinweises auf die Patenterteilung: **31.05.2006**
(21) Anmeldenummer: 02005748.5
(22) Anmeldetag: 13.03.2002
(51) Int. Cl.: H05K 9/00, H01F 27/36

(54) **Magnetfeldschirmung**
Magnetic Shielding
Blindage magnétique

(30) Priorität: 13.03.2001 DE 10112326
(43) Veröffentlichungstag der Anmeldung: 18.09.2002
(73) Patentinhaber: Schulz, Uwe, EMV-tech, 15711 Königs Wusterhausen (DE)
(72) Erfinder:
(74) Vertreter: Effert, Bressel und Kollegen

(56) Entgegenhaltungen:
- US-A- 3 173 116
- US-A- 3 538 472
- US-A- 3 714 483
- US-A- 4 749 979

## Beschreibung

Die Erfindung betrifft eine Abschirmanordnung gegen Magnetfelder, insbesondere von niederfrequent arbeitenden elektrischen Bauteilen im Frequenzbereich von 10 bis 1000 Hz, unter Verwendung metallischer Bleche.

Eine wichtige Maßnahme zum Schutz von elektrischen Bauteilen, Geräten und Anlagen gegen elektromagnetische Felder ist eine Abschirmung oder Schirmung. Mit einer Schirmung sollen aus der Umgebung kommende Störfelder verhindert oder begrenzt werden, insbesondere elektromagnetische Streufelder, die von elektrischen Bauteilen erzeugt werden und ihre Umgebung störend beeinflussen, abzuschirmen.
Die elektromagnetische Verträglichkeit (EMV) wird zunehmend unter dem Gesichtspunkt des Schutzes der Menschen vor einer möglichen Gefährdung durch diese elektromagnetischen Felder diskutiert und durch extrem empfindliche Messverfahren festgestellt. Auf die Messverfahren gehen z.B. die deutschen Normen DIN VDE 01701 und DIN VDE 0848 ein.
Die Abschirmwirkung, z.B. eines Gehäuses um ein elektrisches Bauteil, hängt von der Permeabilität des Werkstoffes, aus dem das Gehäuse gefertigt ist und von dessen Form und Größe sowie der Wanddicke des Werkstoffes ab. Eine Berechnung ist schwierig, da in der Regel Werkstoffe, insbesondere die heute verwendeten weichmagnetischen Werkstoffe, eine mehr oder weniger ausgeprägte Abhängigkeit der Permeabilität von der magnetischen Feldstärke bzw. von der Induktion im Material haben.

Alle Werkstoffe zeigen bei einer bestimmten Feldstärke eine maximale Permeabilität µ-max. Prinzipiell kann aber durch geschickte Dimensionierung der Abschirmung die Maximalpermeabilität als die für die Schirmung wirksame Permeabilität genutzt werden. Bei kleinen Feldstärken kann mit einer Permeabilität gerechnet werden, die sich oft nur wenig von der Anfangspermeabilität µ-0 bei magnetischen Feldstärke H = 0 unterscheidet. Eine optimale Schirmwirkung wird erreicht, wenn bei einer bestimmten magnetischen Induktion eine Maximalpermeabilität erreicht wird. Weil aber oft die Schwankungen der Störfeldamplituden sehr groß sind, arbeitet man sicherheitshalber eher deutlich unterhalb einer solchen Maximalpermeabilität. Unter der in der Schirmwandung noch zulässigen Induktion bₘ wird diejenige Induktion verstanden, bei der die Permeabilität bei wachsender Ansteuerung auf ein tolerierbaren Wert abgesunken ist. Diese Beziehungen und der Hysterese-Einfluss und ähnliches sind dargestellt in der Firmenschrift Magnetische Abschirmungen, Vakuumschmelze GmbH, 1988, Hanau, DE. Für die Definition der Wirkung der Abschirmung wird in der Regel ein Schirmfaktor angegeben, als Verhältnis zwischen der äußeren Störfeldstärke durch z.B. das elektrische Bauteil ausgelöst und der im Inneren eines Gehäuses oder hinter einer Abschirmung gemessenen Restfeldstärke. Der Schirmfaktor wird auch häufig als Schirmdämpfung in dB angegeben. In der Firmenschrift werden des weiteren dann Materialien dargestellt, z.B. Folien aus MUMETALL® oder VITROVAC® (Marken der Vakuumschmelze GmbH). Es handelt sich dabei um weichmagnetische Fe-Legierungen, die in einem speziellen Verfahren hergestellt werden und eine relativ geringe Anfangspermeabilität bei hoher Maximalpermeabilität aufweisen. Es werden dabei Schirmmaterialdicken je nach Anwendungszweck von einigen hundertstel Millimeter bis zu 2 mm verwendet.

Die praktische Verwendung derartiger Folien sind in der Firmenschrift "Magnetische Abschirmfolien" aus 1993 und "Monitorabschirmungen" aus 1997 der selben Firma Vakuumschmelze GmbH dargestellt. In einer Firmenschrift aus 1996 "Weichmagnetische Werkstoffe und Halbzeuge", Vakuumschmelze GmbH, sind eine Vielzahl von Werkstoffen dargestellt und deren Verwendungszweck, beispielsweise NiFe - Legierungen mit 30 % Nickel und mehr; SiFe - Legierungen mit 3 % Silizium und mehr, sowie CoFe-Legierungen mit 47 % und mehr Co und Reineisenmetalle, die durch spezielle Glühverfahren zu kristallinen, weichmagnetischen Legierungen und Halbzeugen geformt werden, vorzugsweise zu Banddicken > 0,3 mm. Vorgestellt worden sind auch Legierungen mit Übergangsmetallen, die dann als nanokristalline und mindestens teils als amorphe Legierungen Verwendung finden sollen. Die Offenbarungen in diesen Firmenschriften werden durch ihre Zitierung zur Offenbarung dieser Anmeldung gemacht.

Aus einem Katalog STABOCOR ORSI der Firma EBG, Gesellschaft für elektromagnetische Werkstoffe mbH, Gelsenkirchen, DE sind kornorientierte Elektrobleche der Typen ORSI und ORSI H bekannt, die durch eine spezielle Glühbehandlung nach dem Kaltwalzen und gegebenenfalls eine Laserbehandlung sehr geringe Ummagnetisierungsverluste beim Einsatz als Elektrobleche aufweisen. Diese spannungsarmen geglühten Bänder werden vorwiegend für Transformatoren und ähnliches als Kernbleche verwendet und weisen eine ausgesprochene Textur auf. Obwohl derartige Bleche in weiten Grenzen eine variable Dicke haben, werden sie vorwiegend in Dicken von 0,35 bis 1 mm produziert und verwendet. Es handelt sich im wesentlichen um reine Stahlbleche, so dass deren Wichte dem von Stahl entspricht im Gegensatz zu den zuvor beschriebenen Blechen, deren spezifisches Gewicht/Dichte deutlich oberhalb von Stahl liegt.

Das bisher aus Kostengründen im wesentlichen nur für Abschirmgehäuse bei niederfrequenten magnetischen Feldern verwendete Material z.B. das schon genannte MUMETALL läßt sich aus Kostengründen kaum einsetzen für größere Raum- oder Flächenabschirmungen, wie sie für Kabinen oder kompletten Rechenzentren und ähnliches verwendet werden müssten. Derartige Raumabschirmungen oder Flächenabschirmungen werden heute z.B. von Medizinern für Menschen gefordert oder um magnetfeldempfindliche Arbeitsräume, die neben Transformatoren oder Niederspannungshauptverteilern oder ähnliches in Gebäuden liegen, weitestgehend zu schützen. Daher finden für derartige Zwecke die zuvor beschriebenen Bleche aus ORSI-Material mit einer hohen Anfangspermeabilität Verwendung. Die Abschirmwerte sind jedoch nicht zufriedenstellend.

In der Druckschrift DE 199 03041 A1 wird ebenfalls von Abschirmgehäusen für einzelne Monitore oder ähnliches berichtet, da eine Raumschirmung - nach fachmännischer Ansicht - aus den gegebenen physikalischen Randbedingungen nicht in Betracht käme. Dort werden als Alternative Kompensationsleitungen vorgeschlagen.

Mit der Patentanmeldung gemäß der DE 198 53239 A1 wird eine Schutzvorrichtung für Personen vorgeschlagen, die Gehäuse von Magnetfelderzeugern mit dicken Farbanstrichen zu versehen und in diese Schichten weichmagnetische Werkstoffe mit Teilchengrößen von max. 1 mm Länge und 0,3 mm Stärke einzubringen. Damit soll zu den erzeugten magnetischen Wechselfeldern des Magnetfelderzeugers ein Gegenfeld erzeugt werden. Der Anstrich soll so gestaltet sein, dass eine Kompensation der Wechselfeldstärke auf unter 0,5 µT möglich ist.

Ähnlich aufwändige Maßnahmen werden mit der Druckschrift DE 199 11132 A1 vorgeschlagen. Eine magnetische Abschirmung für z.B. Monitore soll mittels Partikeln aus weichmagnetischen Materialien wie Kobalt-Legierungen oder nanokristallinen Fe-Legierungen mit max. 1mm Größe in Schichten von max. 50 µm Stärke erreicht werden. Dabei sollen die gemahlenen und geschichteten Partikel durch ein aushärtendes Bindemittel fixiert werden.

Mit beiden zuletzt genannten Vorschlägen lassen sich zwar einzelne Geräte unter sehr hohem Aufwand abschirmen, für eine Massenfertigung von Gehäusen oder Raumschirmungen sind diese Systeme nicht finanzierbar oder in verständiger Bauzeit realisierbar.

Aus der WO 00/33629 ist für hochfrequente elektromagnetische Strahlung bekannt, Schaltschränke zur Schirmung an Spalten mit Stahlblech und zusätzlich mit elektrisch leitenden Kunststofffolien abzuschirmen.
Aus der WO 96/20616 ist letztlich bekannt Monteure an Rundfunkantennen mit EMV-Schutzanzügen zur Abschirmung auszustatten, bei denen der Anzug aus einem Gewebe mit Metallbeschichtung oder Metallfäden besteht.

Aus der US 3,714,483 A ist eine geblechte Magnetfeldabschirmung für Eisenteile an elektrischen Maschinen wie Generatoren bekannt Als Metallbleche werden konventioneller Dynamo Stahl und Bleche aus Aluminium, Messing oder Kupfer vorge-srhlagen. Durch Verweis auf die Herstellung von Dynamo Stahl in einer weiteren Veröffentlichung, die sich mit komorientiertem und nicht komorientiertem Fe-Blech mit hoher Anfangspermeabilität beschäftigt, werden die Eigenschaften derartiger Stähle teils ebenfalls offenbart. In der Kombination des mehrere cm dicken Blechpaketes soll das NE-Blech die letzte Sperrschicht eines mehrschichtigen Kombinationsmaterial bilden.

Von diesem Stand der Technik ausgehend liegt der Erfindung das Problem zugrunde, eine verbesserte Schirmwirkung gegen niederfrequente elektromagnetische Strahlung von Geräten oder Leitungen, insbesondere für Räume, zu finden, die bei möglichst geringen Kosten realisierbar ist.

Erfindungsgemäß wird das Problem durch die Merkmale der Ansprüche 1 und 6 gelöst. Weiterbildungen der Erfindung sind in den Unteransprüchen definiert.

Die Lösung sieht vor, die bisher eingesetzten preiswerten Bleche, beispielsweise der Sorten ORSI oder ORSI H oder ähnliche in Verbindung mit anderen Materialien zu verwenden nach Art einer Sandwich-Blech-Schirmung, d.h. die Übereinander-Verlegung von flächigen Schirm-Materialien ferromagnetischer und nicht-ferromagnetischer Werkstoffe. Vorwiegend zum Einsatz kommen im Zusammenhang mit den hochpermeablen kornorientierten nanokristallinen Blechen auf Fe-Basis, die eine hohe Anfangspermeabilität aufweisen, insbesondere Nicht-Eisen-Metalle, wie Kupfer, Aluminium und Legierungen derselben mit Fe, zum Einsatz, aber auch andere nichtferromagnetische Werkstoffe, vorzugsweise als dünne Bleche oder Folien, auch in Verbindung mit Kunststoffen z.B. als Trägerstoff, Haftvermittler etc. geformt, können benutzt werden.

Erfindungsgemäß werden dabei hochpermeable kornorientierte Bleche ihrer Textur entsprechend in X-Richtung, z.B. längs als auch in Y-Richtung, z.B. quer zueinander als zwei Schichten verlegt und zwischen diese beiden Schichten aus Fe-Blechen wird eine Schicht aus einem Nicht-Eisen-Metall, wie Kupfer oder Aluminium oder eine Legierung dieser Metalle mit Fe verlegt.

In einem Beispiel werden diese Bleche nicht als Dreischichtbleche, sondern nur als Zweischichtbleche verlegt, wobei eine Schicht aus dem kornorientierten Fe-Blech z.B. des Typs ORSI H verlegt wird und dazu eine zweite Schicht aus einem anderen Kombinationsmaterial, nämlich aus Kupfer oder aus Alu oder eine Legierung mit Fe bestehende Materialkomponente. Dabei ist es gleichgültig wie die Verlegerichtung des Kombinationsmaterials gewählt wird, ob in Y-Richtung oder in X-Richtung spielt keine Rolle.

### Nachfolgend dargestellte Versuche haben die Erfindung bestätigt

### Versuche

Die Versuche erstrecken sich auf praktische Messungen und theoretische Berechnungen zum Nachweis der Wirksamkeit einer Materialkombination zur Abschirmung von niederfrequenten magnetischen Feldern.
Dabei wurden Messungen mit unterschiedlichen Werkstoffen in Form von Metallplatten der Größe 1x2m mit zu erwartender hoher Anfangspermeabilität verwendet und eine Materialkombination.

| | |
|---|---|
| **Messaufbau:** | |
| **Felderzeuger:** | Luftspule 25cm Durchmesser an Stelltrafo mit 230V/50Hz. |
| **Messgerät:** | Typ Wandel & Goltermann NF-Magnetfeldsonde EFA200 |
| **Messau**f**bau:** | Holzkonstruktion zur horizontalen Lagerung der Abschirmplatten; Freifeldaufbau zur Vermeidung von Fremdbeeinflussungen; Stelltrafo unter den Abschirmplatten angeordnet |
| **Messung:** | Gemessen wurde die physikalische Größe: |

Magnetische Flussdichte in µT im Frequenzbereich von 5Hz bis 30kHz in drei Ebenen X/Y/Z isotrop (gleichzeitig); festgehalten wurden die Maximalwerte.

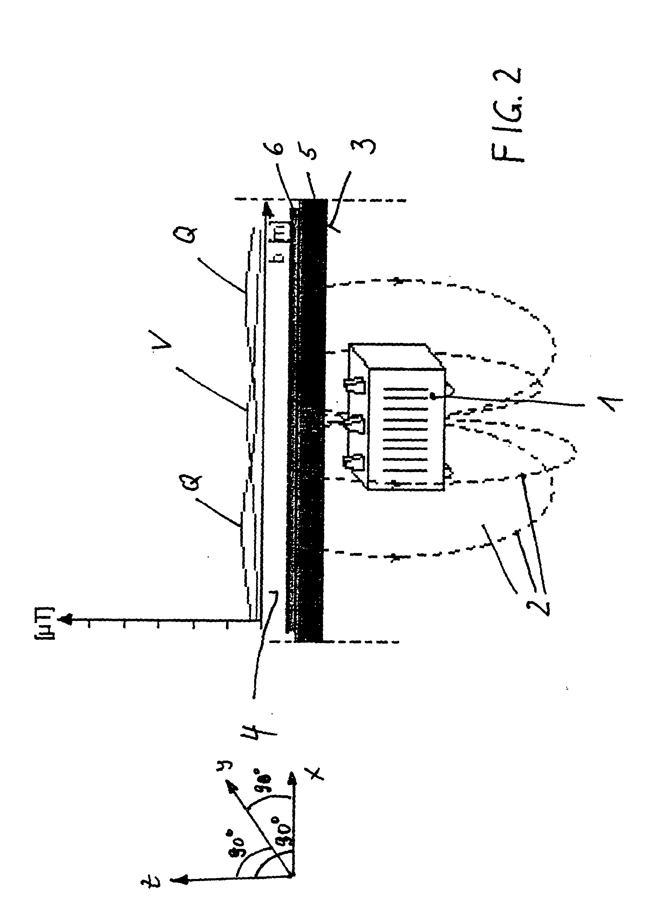

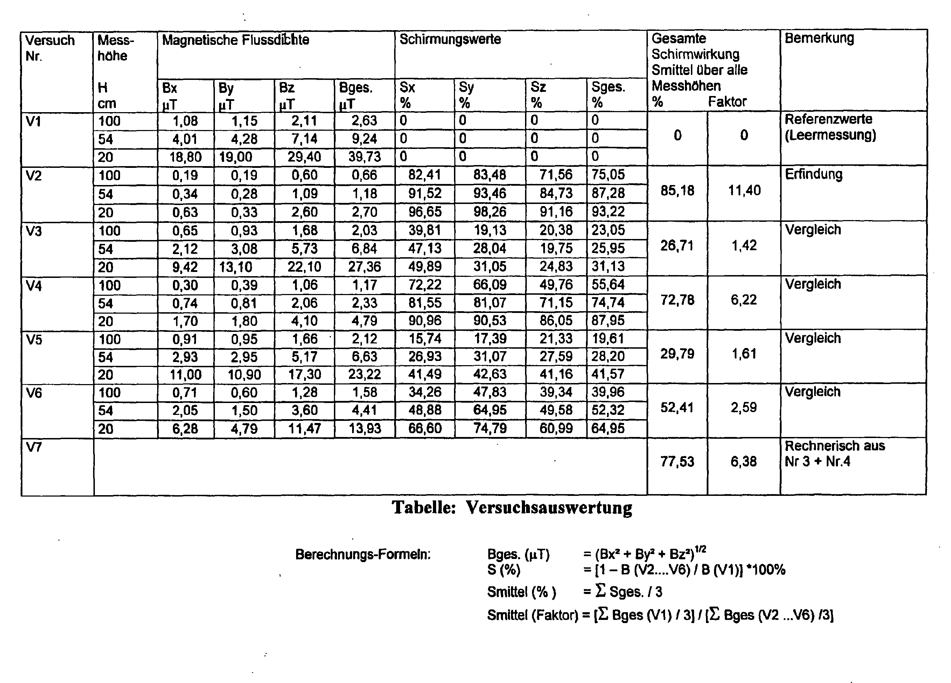

Die Messwerte der Magnetfeldsonde wurden isotrop in 3 Höhenpunkten von 20, 54, 100 cm mittig über den Abschirmplatten / untersuchten Materialien und deren Kombination aufgenommen.
Die Polarisation der felderzeugenden Luftspule wurde unterhalb der Abschirmplatten in den 3 Richtungen X,Y,Z (Richtung der Spulenachse, dargestellt in Fig. 2), jeweils im gleichen Abstand zu den Abschirmplatten verändert.

### Untersuchte Materialien :

### Fe-Elektroblech,

kornorientiert hochpermeabel M150-35S (M6), beidseitig sogenannte Carlite-Isolierung zur besseren Verarbeitung von Elektroblechen zum Paket, bzw. das Verhalten im Paket, hier im Besonderen beim Verschweißen,
in Platten 1x2m, Stärke 0,35 mm (Hersteller: Klöckner & Co)

### Aluminiumplatten,

Standardaluminium Al Mg 3, halbhart G22, DIN 1783, in Platten 1x2m, Stärke 2mm

### Standard-Stahlblech St 37,

Standard- Handelsware, in Platten1x2m, Stärke 1 mm

### ARMCO-Reineisenblech,

Standard-Handelsware, in Platten 1x2m, Stärke 2 mm

### Versuchsvarianten:

1. Leermessung ohne Abschirmmaterial zwischen Felderzeuger und Messgerät zur Referenzwertermittlung
2. Messung mit Kombination von Fe - Elektroblech und einer abschließenden Aluminiumplatte auf der Seite des Messgerätes in der Folge:
   - Schicht Elektroblech in X-Richtung
   - Schicht Elektroblech in Y-Richtung
   - Schicht Elektroblech in X-Richtung
   - Schicht Elektroblech in Y-Richtung
   - Schicht Aluminium 2mm
3. Vergleichsmessung nur mit einer Schicht Aluminium
4. Vergleichsmessung mit vier Schichten Fe - Elektroblech, angeordnet wie im Versuch 2, jedoch ohne Aluminium-Schicht
5. Vergleichsmessung mit einer Schicht Standard-Stahlblech
6. Vergleichsmessung mit einer Schicht ARMCO -Reineisen
7. Rechnerische Kombination der Ergebnisse der Versuche 3 und 4

### Auswertung der Versuche:

Die Ergebnisse der Versuche sind aus der anhängenden Tabelle: Versuchsauswertung ersichtlich. Dargestellt sind die oben genannten 7 Versuche V1 bis V7 mit den unterschiedlichen Messhöhen sowie die dabei gewonnenen Messwerte B in µT. Derauf eine Höhe bezogene Wert Bges. Wurde als Wurzel aus der Addition der Quadrate der einzelne Messwerte berechnet, wie es die Formel unter der Tabelle angibt.
Die den einzelnen Messwerten zuzuordnenden Schirmungswerte S in % und der Gesamtwert Sges sowie die Mittelwerte Smittel der Versuche wurden ebenfalls nach den unter der Tabelle notierten Formeln berechnet.

Die Schirmwirkung in Prozentangaben der Feldschwächung und als Schirmfaktor ergeben sich aus der mathematischen Relation je Versuch im Vergleich zur Leermessung im Versuch V1.

Die Kombination gemäß Versuch V2 mit hochpermeablem kornorientiertem Elektroblech und Aluminium als Schichtverbund, in mehreren Lagen übereinander verarbeitet, bietet erfindungsgemäß hervorragende Schirmwirkungen gegenüber niederfrequenten elektromagnetischen Feldern. Anscheinend wird durch den bei vertikalem Feldeintritt entstehenden Wirbelstromeffekt im Kombinationsmaterial Aluminium ein Gegenfeld erzeugt, welches für die Schirmwirkung dieses Feldanteils wirksam wird. Es entsteht höchstwahrscheinlich ein Synergieeffekt, der bei dieser Messung nicht weiter untersucht worden ist.

In Kombination mit hochpermeablem kornorientiertem Elektroblech mit hoher Korngröße ergibt sich also ein Material, welches für die Abschirmung aller Feldanteile hochwirksam ist.
Die Messungen haben gezeigt, dass die kumulierte synergistische Schirmwirkung dieser Kombination höher ist als die rechnerische Addition der Schirmwirkungen beider Einzelkomponenten, was der Versuch V7 ohne Messungen, als rechnerische Ermittlung aus den Versuchen V3 und V4, im Vergleich zu Versuch V2 belegt. Es wird bei der dokumentierten Materialanordnung ein Spitzenwert von über 85% Abschirmung der ursprünglichen Strahlung (V1) bzw. ein Schirmfaktor von 11,4 erreicht. Der Fachmann kann durch Experimente mit den Texturen der Bleche und deren Stärke noch Optimierungseffekte erzielen sowohl bezüglich der Schirmwirkung als auch bezüglich der Material- und Montagekosten.

Alle anderen untersuchten Alternativen ergaben keine zufriedenstellenden Schirmwirkungen, was der Versuch V6 schon nahe legt wegen schlechterer Werte als Versuch V4 belegt, unter Verwendung des bisher als hervorragend bewerteten Armco-Reineisen.

Die vorteilhafte erfinderische Materialkombination findet u.a. Anwendung bei der Abschirmung von Energieleitungen und Transformatoren, insbesondere in Gebäuden.
Im Gegensatz zu anderen getesteten Materialien lässt sich diese Kombination aufgrund der schon bei geringer Materialstärke (geringes Gewicht) entstehenden hohen Schirmwirkung in der Praxis hervorragend bei akzeptablen Installationskosten einsetzen. Aufwändige, nach der Installation anfallende Verfahren, z.B. eine Schlussglühung wie bei MUMETALL, können entfallen.

Der Erfinder hat festgestellt, dass bei einer derartigen Sandwich-Blech-Anordnung an den Wänden, Böden, Decken eines zu schirmenden Raumes die Kombination der Materialien starke Wirbelstromeffekt-Eigenschaften erzeugt, die dazu führen, dass die messbare Feldstärken auf ein Minimum absinken, sowohl bei den Querfeldern als auch bei den Vertikalfeldem in dem geschützten Raum. Dasselbe gilt natürlich auch für Gehäuse aus dem Kombinationsmaterial für elektrische Geräte, deren Fertigung nun einfacher und preiswerter ist als nach dem Stand der Technik bei verbesserter Schirmwirkung.

Anhand einer Zeichnung soll diese Erfindungswirkung grafisch verdeutlicht werden.

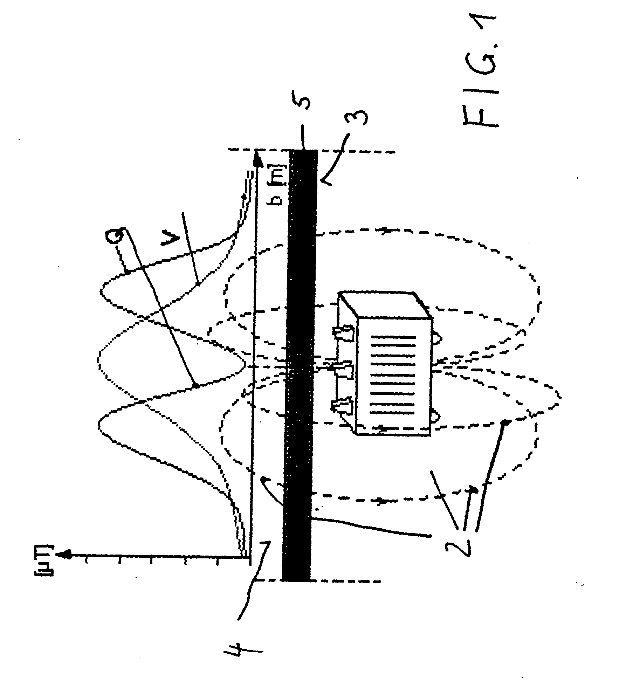

Die Figur 1 zeigt einen Raum 4 ohne Schirmung und Figur 2 den Raum 4 hinter der Wand 5, die den Raum 4 von einem Raum 3 mit Trafo / niederfrequent arbeitendem elektrischem Bauteil 1 trennt, z.B. mit einer Schirmung 6 aus dem erfindungsgemäßen Kombinationsmaterial. Das Magnetfeld 2 erstreckt sich durch die Wand 5 mit einem Querfeld Q und einem Vertikalfeld V, dargestellt in dem Diagramm im Raum 4, wobei die Stärke des Feldes in Fig. 2 bei Schirmung auf ein Minimum absinkt. X, Y, Z bezeichnen die dem Fachmann geläufigen Richtungen der Spulenachsen gemäß der Versuchsanordnung, die jeweils unter 90° zueinander angeordnet sind.

## Patentansprüche

1. Abschirmanordnung für Magnetfelder (2, Q, V), insbesondere von niederfrequent arbeitenden elektrischen Bauteilen (1) im Frequenzbereich von 10 bis 1000 Hz, unter Verwendung metallischer Bleche in Schichten aus komorientiertem Fe-Blech mit hoher Anfangspermeabilität und nicht-ferromagnetischen Kombinationsmaterialien, **gekennzeichnet durch** ein mindestens dreischichtiges Kombinationsmaterial (6) mit zwei Schichten aus Fe-Walzmaterial deren Texturen quer zueinander verlaufen und einer Schicht aus einem NE-Metall.

2. Anordnung nach Anspruch 1, **dadurch gekennzeichnet, dass** die Schicht eines nicht-ferromagnetischen Materials aus Aluminium oder Kupfer besteht.

3. Anordnung nach einem der vorhergehenden Ansprüche, **gekennzeichnet durch** ein Kombinationsmaterial (6) getrennt aufeinander liegender Metallschichten.

4. Anordnung nach einem der vorhergehenden Ansprüche, **dadurch gekennzeichnet, dass** eine Zwischenschicht aus einem NE-Metall besteht.

5. Anordnung nach einem der vorhergehenden Ansprüche, **dadurch gekennzeichnet, dass** die Schichten des Kombinationsmaterials(6) aus Fe-Schichten mit bis zu 2 mm, vorzugsweise 0,35 mm, starkem Fe-Blech und aus bis zu 3 mm, vorzugsweise etwa 2 mm starkem, Al-Blech bestehen.

6. Verwendung einer Abschirmanordnung nach Anspruch 1 als Abschirmmaterial (6) für flächige Raumabschirmung (5) zur Abschirmung gegen elektromagnetische niederfrequente Sbahlung (Z, Q, V) von Geräten, elektrischen Bauteilen (1) oder Leitungen.

## Claims

1. An arrangement providing screening against magnetic fields (2, Q, V), especially for electrical components (1) operating in the low-frequency range 10-1000 Hz, said arrangement using metal sheets in layers of oriented iron sheet having a high initial permeability and non-ferromagnetic combination materials, **characterised by** a combination material (6) of at least 3 layers: two layers of rolled iron material, the preferred orientations of which extend at right angles to each other, and one layer of a non-ferrous metal.

2. Arrangement according to claim 1, **characterised in that** the layer of a non-ferromagnetic material consists of aluminium or copper.

3. Arrangement according to one of the preceding claims, **characterised by** a combination material (6) of metal layers lying separately the one on the other.

4. Arrangement according to one of the preceding claims, **characterised in that** an intermediate layer consists of a non-ferrous metal.

5. Arrangement according to one of the preceding claims, **characterised in that** the layers of the combination material (6) comprise iron layers of iron sheet which is up to 2 mm, preferably 0.35 mm thick, and aluminium sheet which is up to 3 mm, preferably roughly 2 mm thick.

6. Use of a screening arrangement according to claim 1 as screening material (6) for flat spatial screens (5) for screening equipment, electrical components (1) or leads from electromagnetic low-frequency radiation (2, Q, V).

## Revendications

1. Dispositif de blindage pour champs magnétiques (2, Q, V), en particulier de pièces électriques travaillant en basses fréquences (1) dans le domaine de fréquences de 10 à 1000 Hz, par utilisation de tôles métalliques en couches de tôles de fer à grains orientés avec forte perméabilité initiale et matériaux combinés ferromagnétiques, **caractérisé par** un matériau combiné (6) à au moins trois couches avec deux couches de matériau à base de fer laminé dont les orientations préférentielles sont à la perpendiculaire l'une de l'autre, et une couche d'un métal non ferreux.

2. Dispositif selon la revendication 1 **caractérisé en ce que** la couche de matériau non ferromagnétique se compose d'aluminium ou de cuivre.

3. Dispositif selon une des revendications précédentes **caractérisé par** des couches de métal couchées les unes sur les autres séparées par un matériau combiné (6).

4. Dispositif selon une des revendications précédentes **caractérisé par** la présence d'une intercouche de métal non ferreux.

5. Dispositif selon une des revendications précédentes **caractérisé en ce que** les couches du matériau combiné (6) se composent de couches ferreuses avec une couche de fer jusqu'à 2 mm d'épaisseur, de préférence 0,35 mm, et d'une couche d'aluminium jusqu'à 3 mm d'épaisseur, de préférence environ 2 mm.

6. Utilisation d'un dispositif de blindage selon la revendication 1 comme matériau de blindage (6) pour protection plane d'espace (5) pour protection contre les rayonnements électromagnétiques de basse fréquence (2, Q, V) issus d'appareils, d'élements de construction électriques (1) ou de câbles.
